Europäisches Patentamt

European Patent Office

Office européen des brevets

(19)

(11) **EP 0 413 391 B1**

(12) # EUROPEAN PATENT SPECIFICATION

(45) Date of publication and mention
of the grant of the patent:
**27.11.1996 Bulletin 1996/48**

(51) Int Cl.[6]: **G10L 9/14**

(21) Application number: **90202178.1**

(22) Date of filing: **10.08.1990**

(54) **Speech coding system and a method of encoding speech**

System und Methode zur Sprachkodierung

Système et méthode de codage de la parole

(84) Designated Contracting States:
**DE FR GB IT SE**

(30) Priority: **16.08.1989 GB 8918677**

(43) Date of publication of application:
**20.02.1991 Bulletin 1991/08**

(73) Proprietors:
- **PHILIPS ELECTRONICS UK LIMITED**
 **Croydon CR9 3QR (GB)**
 Designated Contracting States:
 **GB**
- **Philips Electronics N.V.**
 **5621 BA Eindhoven (NL)**
 Designated Contracting States:
 **DE FR IT SE**

(72) Inventors:
- **Moulsley, Timothy James**
 **Surrey RH1 5HA (GB)**
- **Elliott, Patrick William**
 **Surrey RH1 5HA (GB)**

(74) Representative: **Moody, Colin James et al**
 **Philips Electronics UK Limited**
 **Patents and Trade Marks Department**
 **Cross Oak Lane**
 **Redhill, Surrey RH1 5HA (GB)**

(56) References cited:
- **SIGNAL PROCESSING IV (PROCEEDINGS OF EUSIPCO'88, FOURTH EUROPEAN SIGNAL PROCESSING CONFERENCE, Grenoble, 5th - 8th September 1988), vol. II, pages 871- 874, North-Holland, Amsterdam, NL; F. BOTTAU et al.: "On different vector predictive coding schemes and their application to low bit rates speech coding"**
- **SPEECH COMMUNICATION, vol. 7, no. 2, July 1988, pages 217-226, Amsterdam, NL; A. LE GUYADER et al.: "A robust and fast CELP coder at 16 Kbit/s"**
- **ICASSP'89 (1989 INTERNATIONAL CONFERENCE ON ACOUSTICS, SPEECH, AND SIGNAL**
- **PROCESSING, Glasgow, 23rd - 26th May 1989, vol. 1, pages 65-68, IEEE, New York, US; N.S. JAYANT et al.: "Speech coding with time-varying bit allocations to excitation and LPC parameters"**
- **SPEECH COMMUNICATION, vol. 8, no. 4, December 1989, pages 363-369, Amsterdam, NL; J.-M. MÜLLER: "Improving performance of code excited LPC-coders by joint optimization"**
- **SPEECH COMMUNICATION, vol. 7, no. 3, October 1988, pages 305-316, Amsterdam, NL; W.B. KLEIJN et al.: "An efficient stochastically excited linear predictive coding algorithm for high quality bit rate transmission of speech"**

**Description**

The present invention relates to a speech coding system and to a method of encoding speech and more particularly to a code excited speech coder which has application in digitised speech transmission systems.

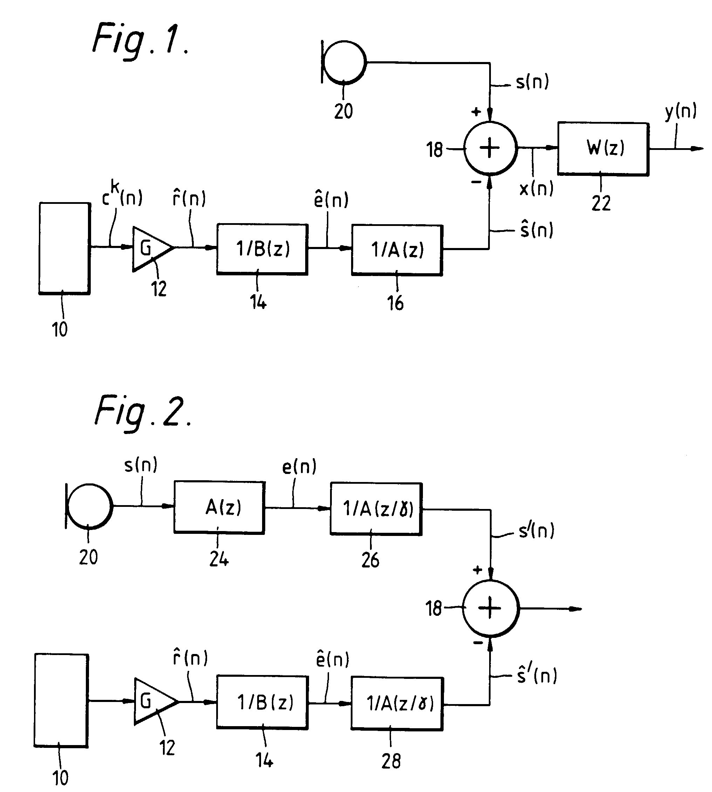

When transmitting digitised speech a problem which occurs is how to obtain high quality speech over a bandwidth limited communications channel. In recent years a promising approach to this problem involves Code-Excited Linear Prediction (CELP) which is capable to producing high quality synthetic speech at low bit rate. Figure 1 of the accompanying drawings is a block schematic diagram of a proposal for implementing CELP and is disclosed for example in a paper "Fast CELP Coding Based on Algebraic Codes" by J-P Adoul, P. Mabilleau, M. Delprat and S. Morissette and read at International Conference on Acoustics Speech and Signal Processing (ICASSP) 1987 and reproduced on pages 1957 to 1960 of ICASSP87. In summary CELP is a speech coding technique which consists in representing a residual signal by an optimum temporal waveform of a code-book with respect to subjective error criteria. More particularly a codebook sequence $c_k$ is selected which minimises the energy in a perceptually weighted signal y(n) by for example using Mean Square Error (MSE) criterion to select the sequence. In Figure 1 a two-dimensional code-book 10 which stores random vectors $c_k(n)$ is coupled to a gain stage 12. The signal output $\hat{r}(n)$ from the gain stage 12 is applied to a first inverse filter 14 constituting a long term predictor and having a characteristic 1/B(z), the filter 14 being used to synthesise pitch. A second inverse filter 16 constituting a short term predictor and having a characteristic 1/A(z) is connected to receive the output ê(n) of the first filter 14. The second filter synthesises the spectral envelope and provides an output $\hat{s}(n)$ which is supplied to an inverting input of a summing stage 18. A source of original speech 20 is connected to a non-inverting input of the summing stage 18. The output x(n) of the summing stage is applied to a perceptual weighting filter 22 having a characteristic W(z) and providing an output y(n).

In operation the comparatively high quality speech at low bit rate is achieved through an analysis-by-synthesis procedure using both short-term and long-term prediction. This procedure consists of finding the best sequence in the code-book which is optimum with respect to a subjective error criterion. Each code word or sequence $c_k$ is scaled by an optimum gain factor $G_k$ and is processed through the first and second inverse filters 14,16. The difference x(n) between the original and the synthetic signals, that is s(n) and $\hat{s}(n)$, is processed through the perceptual weighting filter 22 and the "best" sequence is then chosen to minimise the energy of the perceptual error signal y(n). Two reported criticisms of the proposal shown in Figure 1 are the large number of computations arising from the search procedure to find the best sequence and the computations required from filtering of all the sequences through both long-term and short-term predictors.

The above-mentioned paper reproduced on pages 1957 to 1960 of ICASSP 87 proposes several ideas for reducing the amount of computation.

A block schematic implementation of one of these ideas is shown in Figure 2 of the accompanying drawings in which the same reference numerals as have been used in Figure 1 to indicate corresponding parts. This implementation is derived from expressing the perceptual weighting filter 22 (Figure 1) as

$$W(z) = A(z)/A(z/\gamma)$$

where $\gamma$ is the perceptual weighting coefficient (chosen around 0.8) and A(z) is a linear prediction filter:

$$A(z) = \Sigma_i a_i z^{-i}.$$

Compared to Figure 1, the perceptual weighting filter W(z) can be moved to the signal input paths to the summing stage 18. Thus the original speech from the source 20 is processed through an analysis filter 24 having a characteristic A(z) yielding a residual signal e(n) from which pitch parameters are derived. The residual signal e(n) is processed through an inverse filter 26 having a characteristic $1/A(z/\gamma)$ and yielding a signal s'(n) which is applied to the non-inverting input of the summing stage 18.

In the other signal path, the short term predictor constituted by the second inverse filter 16 (Figure 1) is replaced by an inverse filter 28 having a characteristic $1/A(z/\gamma)$ which produces an output $\hat{s}'(n)$.

The long term predictor, the filter 14, can be chosen to be a single tap predictor:

$$B(z) = 1-bz^{-T} \qquad\qquad - (1)$$

where b is the gain and T is called the pitch period. The expression of the output signal ê(n) of the pitch predictor 1/B(z) can be derived from the above equation (1)

$$\hat{e}(n) = r(\hat{n}) + b\hat{e}(n-T) \qquad\qquad - (2)$$

where $r(n) = G_k c_k(n)$, where $n = 0$, $N - 1$ and $N$ is the block size or length of the codewords, where $k$ is the codebook index and $G_k$ is a gain factor.

During the search procedure, the signal $\hat{e}(n-T)$ is known and does not depend on the codeword currently being tested if $T$ is constrained to be always greater than $N$. Thus it is possible for the pitch predictor $1/B(z)$ to be removed from the signal path from the two-dimensional codebook 10 if the signal $b\hat{e}(n-T)$ is subtracted from the residual signal in the path from the speech source 20. Using expression (2), the signal $\hat{e}(n-T)$ is obtained by processing the delayed signal $\hat{r}(n-T)$ through the pitch predictor $1/B(z)$; and $\hat{r}_{n-T}$ is computed from already known codewords, chosen from preceding blocks, provided that the pitch period $T$ is restricted to values greater than the block size $N$. The operation of the pitch predictor can also be considered in terms of a dynamic adaptive codebook.

This paper also discloses a scheme whereby the long term predictor $1/B(z)$ and the memory of the short-term predictor $1/A(z/\gamma)$ are removed from the signal path from the codebook 10. As a consequence it is possible to reduce two filtering operations on each codeword to a single memoryless filtering per codeword with a significant cut in the computational load.

Another paper, "On Different Vector Predictive Coding Schemes and Their Application to Low Bit Rates Speech Coding" by F. Bottau, C. Galand, M. Rosso and J. Menez, pages 871 to 874 of EURASIP 1988 discloses an approach to CELP coding, which allows the speech quality to be maintained assuming a given level of computational complexity without increasing the memory size.

This paper discloses sub-dividing a 160 sample frame into 6 or 8 blocks to provide a codebook containing 256 sequences. Each sequence is composed of residual signal which simply comprises (N + L) samples, where N is the number of sequences and L the block length to be encoded; $XO(n)$ $n = 1, \ldots (N + L)$. In the new codebook or "line-code", two consecutive code words differ by only one sample. The first code word is composed by the first L samples of the line code:

$$CB(1,n) = XO(n) \ n = 1, L$$

The following code word is then defined by the last (L - 1) samples of the previous one and the next sample of the line code:

$$CB(2, n) = XO(n + 1) \ n = 1, L \text{ and}$$

$$CB(k, n) = XO(n + k - 1) \ n = 1, L$$

It is unnecessary to evaluate or store the energies of each candidate sequence since it is possible to normalize them to a single value. The stated advantages of this codebook are its size enables a reduction in memory cost and decrease in the computational cost.

Although both these papers described methods of improving the implementation of the CELP technique, there is still room for improvement.

According to a first aspect of the present invention there is provided a speech coding system comprising means for filtering digitised speech samples to form perceptually weighted speech samples, characterised by a one-dimensional codebook, means for filtering entries read-out from the one-dimensional codebook to provide a filtered codebook composed of all said entries read-out, and means for comparing entries of the filtered codebook with the perceptually weighted speech samples to obtain a codebook index which gives the minimum perceptually weighted error when the speech is resynthesised.

According to a second aspect of the present invention there is provided a method of encoding speech in which digitised speech samples are filtered to produce perceptually weighted speech samples, characterised by filtering a one-dimensional codebook in its entirety to form a filtered codebook, and comparing the perceptually weighted speech samples with entries from the filtered codebook to obtain a codebook index which gives the minimum perceptually weighted error when the speech is resynthesised.

By using a one-dimensional codebook a significant reduction in the computational load of the CELP coder is achieved because the processing consists of filtering this codebook in its entirety using the perceptually weighted synthesis filter once for each set of filter coefficients produced by linear predictive analysis of the digitised speech samples. The updating of the filter coefficients may be once every four frames of digitised speech samples, each frame having a duration of for example 5mS. The filtered codebook is then searched to find the optimum framelength sequence which minimises the error between the perceptually weighted input speech and the chosen sequence.

If desired every pth entry of the filtered codebook may be searched, where p is greater than unity. As adjacent entries in the filtered codebook are correlated then by not searching each entry the computational load can be reduced without unduly affecting the quality of the speech or alternatively a longer codebook can be searched for the same computational load giving the possibility of better speech quality.

In an embodiment of the present invention the comparison is effected by calculating the sum of the cross products using the equation:

$$E_k = \sum_{n=0}^{N-1} x^2(n) - \frac{\left( \sum_{n=0}^{N-1} x(n) g_k(n) \right)^2}{\sum_{n=0}^{N-1} g_k^2(n)}$$

where

$E_k$ is the overall error term,
N is the number of digitised samples in a frame,
n is the sample number,
x is the signal being matched with the codebook,
$g_k$ is the unscaled filtered codebook sequence, and
k is the codebook index

This is equivalent to searching the codebook index k for a maximum of the expression:-

$$\frac{\left( \sum_{n=0}^{N-1} x(n) g_k(n) \right)^2}{\sum_{n=0}^{N-1} g_k^2(n)}$$

The computation can be reduced (at some cost in speech quality) by evaluating every mth term of this cross product and maximising

$$\frac{\left( \sum_{n=0}^{\frac{N-1}{m}} x(nm) g_k(nm) \right)^2}{\sum_{n=0}^{\frac{N-1}{m}} g_k^2(nm)}$$

where m is an integer having a low value.

The speech coding system may further comprise means for forming a long term predictor using a dynamic adaptive codebook comprising scaled entries selected from the filtered codebook together with entries from the dynamic adaptive codebook, means for comparing entries from the dynamic adaptive codebook with perceptually weighted speech samples, means for determining an index which gives the smallest difference between the dynamic adaptive codebook entry and the perceptually weighted speech samples, means for subtracting the determined entry from the perceptually weighted speech samples, and means for comparing the difference signal obtained from the subtraction with entries from the filtered codebook to obtain the filtered codebook index which gives the best match.

Means may be provided for combining the filtered codebook entry which gives the best match with the corresponding dynamic adaptive codebook entry to form coded perceptually weighted speech samples, and for filtering the coded perceptually weighted speech samples to provide synthesised speech.

The dynamic adaptive codebook may comprise a first-in, first-out storage device of predetermined capacity, the input signals to the storage device comprising the coded perceptually weighted speech samples.

The filtering means for filtering the coded perceptually weighted samples may comprise means for producing an inverse transfer function compared to the transfer function used to produce the perceptually weighted speech samples.

According to a third aspect of the present invention there is provided a method of deriving speech comprising forming a filtered codebook by filtering a one dimensional codebook using a filter whose coefficients are specified in an input signal, selecting a predetermined sequence specified by a codebook index in the input signal, adjusting the amplitude of the selected predetermined sequence in response to a gain signal contained in the input signal, restoring the pitch of the selected predetermined sequence in response to pitch predictor index and gain signals contained in the input signal, and applying the pitch restored sequence to deweighting and inverse synthesis filters to produce a speech signal.

The present invention will now be described, by way of example, with reference to the accompanying drawings, wherein:

Figures 1 and 2 are block schematic diagrams of known CELP systems,
Figure 3 is a block schematic diagram of an embodiment of the present invention, and
Figure 4 is a block schematic diagram of a receiver.

In the drawings the same reference numerals have been used to identify corresponding features.

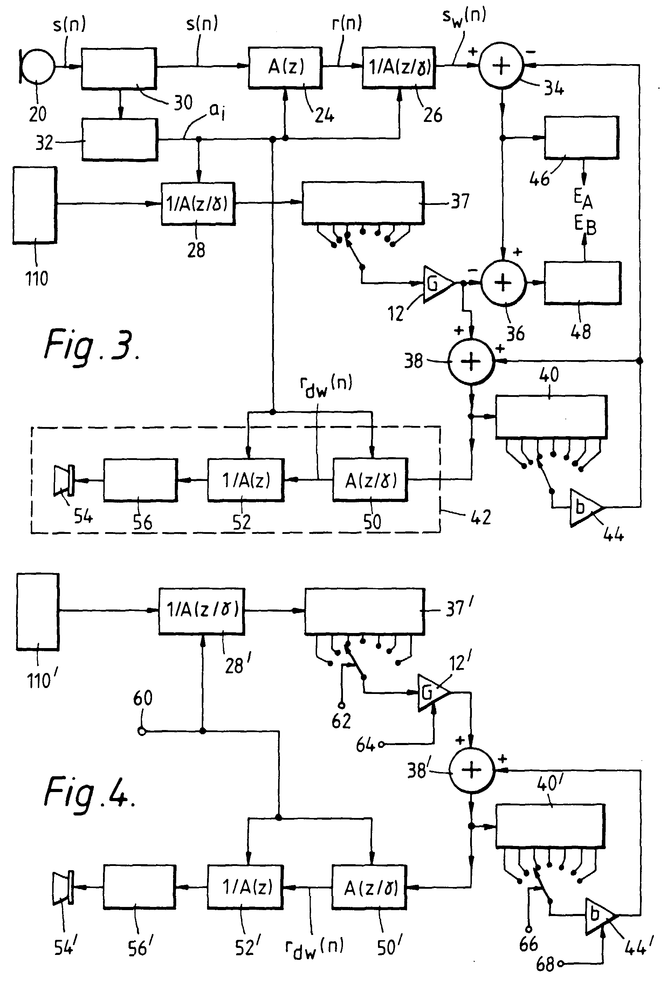

Referring to Figure 3, a speech source 20 is coupled to a stage 30 which quantises the speech and segments it into frames of 5mS duration. The segmented speech s(n) is supplied to an analysis filter 24 having a transfer function A(z) and to a linear predictive coder (LPC) 32 which calculates the filter coefficients $a_i$. The residual signal r(n) from the filter 24 is then processed in a perceptually weighted synthesis filter 26 having a transfer function $1/A(z/\gamma)$. The perceptually weighted residual signal $s_w(n)$ is applied to a non-inverting input of a subtracting stage 34 (which is implemented as a summing stage having inverting and non-inverting inputs). The output of the summing stage 34 is supplied to the non-inverting input of another subtracting stage 36.

A one dimensional (1-D) codebook 110 containing white Gaussian random number sequences is connected to a perceptually weighted synthesis filter 28 which filters the codebook entries and supplies the results to a 1-D filtered codebook 37 which constitutes a temporal master codebook. The codebook sequences are supplied in turn to a gain stage 12 having a gain G. The scaled coded sequences from the gain stage 12 are applied to the inverting input of the subtracting stage 36 and to an input of a summing stage 38. The output of the stage 38 comprises a pitch prediction signal which is applied to pitch delay stage 40, which introduces a preselected delay T, and to a stage 42 for decoding the speech. The pitch delay stage 40 may comprise a first-in, first-out (FIFO) storage device. The delayed pitch prediction signal is applied to a gain stage 44 which has a gain b. The scaled pitch prediction signal is applied to an input of the summing stage 38 and to an inverting input of the subtracting stage 34.

A first mean square error stage 46 is also connected to the output of the subtracting stage 34 and provides an error signal $E_A$ which is used to minimise variance with respect to pitch prediction. A second mean square error stage 48 is connected to the output of the subtracting stage 36 to produce a perceptual error signal $E_B$ which is used to minimise the variance with respect to the filtered codebook 37.

In the illustrated embodiment speech from the source 20 is segmented into frames of 40 samples, each frame having a duration of 5mS. Each frame is passed through the analysis and weighting filters 24, 26; the coefficients $a_i$ for which filters are derived by linear predictive analysis of the digitised speech samples. In a typical application, ten prediction coefficients are required and these are updated every 20mS (the block rate). The weighting filter introduces some subjective weighting into the coding process. A value of $\gamma = 0.65$ has been found to give good results. In the subtracting stage 34, the scaled (long term) pitch prediction is subtracted from the perceptually weighted residual signals $s_w(n)$ from the filter 26. As long as the scaled pitch prediction uses only information from previously processed speech the optimum pitch delay T and gain b (stage 44) can be calculated to minimise the error $E_A$ at the output of the MSE stage 46.

The 1-D codebook 110 comprises 1024 elements all of which are filtered once per 20mS block by the perceptual weighting filter 28, the coefficients of which correspond to those of the filter 26. The codebook search is carried-out by examining vectors composed of 40 adjacent elements from the filtered codebook 37. During the search the starting position of the vector is incremented by one or more for each codebook entry and the value of the gain G (stage 12) is calculated to give the minimum error $E_B$ at the output of the MSE 48. Thus the codebook index and the gain G for the minimum perceptual error are found. This information is then used in the synthesis of the output speech using for example the stage 42 which comprises a deweighting analysis filter 50, an inverse synthesis filter 52, an output transducer 54, and, optionally, a global post filter 56. The coefficients of the filters 50 and 52 are derived from the LPC 32. In a practical situation the information transmitted comprises the LPC coefficients, the codebook index, the codebook gain, the pitch predictor index and the pitch predictor gain. At the end of a communications link, a receiver having a copy of the unfiltered 1-D codebook can regenerate the filtered codebook for each speech block from the received filter coefficients and then synthesise the original speech.

In order to reduce the number of bits required to represent the LPC coefficients, these coefficients were quantised as log-area ratios (L.A.R.'s) which also minimised their sensitivity to quantisation distortion. Alternatively these coefficients may be quantised by using line spectral pairs (LSP) or using inverse sine coefficients. In the present example a block of 10 LPC coefficients quantised as LARs can be represented as 40 bits per 20mS. The figure of 40 bits is made-up by quantising the 1st and 2nd LPC coefficients using 6 bits each, the 3rd and 4th LPC coefficients using 5 bits each, the 5th and 6th LPC coefficients using 4 bits each, the 7th and 8th LPC coefficients using 3 bits each and the 9th and 10th LPC coefficients using 2 bits each. Thus the number of bits per second is 2000. Additionally the frame rate which is updated once every 5mS comprises codebook index - 10 bits, codebook gain, which has been quantised logarithmically, -5 bits + sign bit, pitch predictor index - 7 bits and pitch predictor gain - 4 bits. This totals 27 bits which corresponds to 5400 bits per second. Thus the total bit rate (2000 + 5400) is 7400 bits per second.

The two-dimensional codebook disclosed in Figures 1 and 2 could be represented by:

$$c(i,j) = d(i,j)$$

where $c(i,j)$ is the j'th element of the i'th codebook entry and d is a 2-dimensional array of random numbers. In contrast the codebook used in Figure 3 can be represented by

$$c(i,j) = d(i+j)$$

where d is a 1-dimensional array of random numbers. Typically $1<i<1024$ and $1<j<40$.

The bulk of the calculation in CELP lies in the codebook search, and a considerable amount of this is involved with filtering the codebook. Using a 1-dimensional codebook as described with reference to Figure 3 reduces the codebook filtering by a factor equal to the length of the speech segment.

The comparison of the filtered codebook sequences with the pitchless perceptually weighted residual on the output of the subtracting stage 34 is carried out by calculating the sum of the cross-products using the equation:

$$E_k = \sum_{n=0}^{N-1} x^2(n) - \frac{\left(\sum_{n=0}^{N-1} x(n)g_k(n)\right)^2}{\sum_{n=0}^{N-1} g_k^2(n)}$$

where

E is the overall error term,
N is the number of digitised samples in a frame,
n is the sample number,
x is the signal being matched with the codebook,
$g_k$ is the unscaled filtered codebook sequence, and
k is the codebook index.

The derivation of this equation is based on the equations given on page 872 of the EURASIP, 1988 referred to above.

For the sake of completeness Figure 4 illustrates a receiver. As the receiver comprises features which are also shown in the embodiment of Figure 3, the corresponding features have been identified by primed reference numerals. The data received by the receiver will comprise the LPC coefficients which are applied to a terminal 60, the codebook index and gain which are respectively applied to terminals 62, 64, and the pitch predictor index and gain which are respectively applied to terminals 66, 68. A one dimensional codebook 110′ is filtered in a perceptually weighted synthesis filter 28′ and the outputs are used to form a filtered codebook 37′. The appropriate sequence from the filtered codebook 37′ is selected in response to the codebook index signal and is applied to a gain stage which has its gain specified in the received signal. The gain adjusted sequence is applied to the pitch predictor 40′ whose delay is adjusted by the pitch predictor index and the output is applied to a gain stage 44′ whose gain is specified by the pitch predictor gain signal. The sequence with the restored pitch prediction is applied to a deweighting analysis filter 50′ having a characteristic $A(z/\gamma)$. The output $r_{dw}(n)$ from the filter 50′ is applied to an inverse synthesis filter 52′ which has a characteristic $1/A(z)$. The coefficients for the filters 50′, 52′ are specified in the received signal and are updated every block (or four frames). The output of the filter 52′ can be applied directly to an output transducer 54′ or indirectly <u>via</u> a global post filter 56′ which enhances the speech quality by enhancing the noise suppression at the expense of some speech distortion.

The embodiment illustrated in Figure 3 may be modified in order to simplify its construction, to reduce the degree of computation or to improve the speech quality without increasing the amount of computation.

For example the analysis and weighting filters may be combined.

The size of the 1-dimensional codebook may be reduced.

The perceptual error estimation may be carried out on a sub-sampled version of the perceptual error signal. This would reduce the calculation required for the long term predictor and also in the codebook search.

A full search of the filtered codebook may not be needed since adjacent entries are correlated. Alternatively a longer codebook could be searched, giving better speech quality. In either case every pth entry is searched, where p is greater than unity.

Filtering computation could be reduced if two half length codebooks were used. One could be filtered with the weighting filter from the current frame, the other could be retained from the previous frame. Similarly, one of these half length codebooks could be derived from previously selected codebook entries.

If desired a fixed weighting filter may be used for filtering the codebook.

The embodiment of the invention shown in Figure 3 assumes that the transfer functions of the perceptually weighted synthesis filters 26, 28 are the same. However it has been found that it is possible to achieve improved speech quality by having different transfer functions for these filters. More particularly the value of $\gamma$ for the filters 26 and 50 is the same but different from that of the filter 28.

The numerical values given in the description of the operation of the embodiment in Figure 3 are by way of illustration and other values may be used without departing from the scope of the invention as claimed.

From reading the present disclosure, other modifications will be apparent to persons skilled in the art. Such modifications may involve other features which are already known in the design, manufacture and use of CELP systems and component parts thereof and which may be used instead of or in addition to features already described herein.

## Claims

1.  A speech coding system comprising means (24, 26) for filtering digitised speech samples to form perceptually weighted speech samples, characterised by a one-dimensional codebook (110), means (28) for filtering entries read-out from the one-dimensional codebook to provide a filtered codebook (37) composed of all said entries read-out, means (34, 36, 48) for comparing entries of the filtered codebook with the perceptually weighted speech samples to obtain a codebook index which gives the minimum perceptually weighted error when the speech is resynthesised.

2.  A system as claimed in Claim 1, characterised in that the means for filtering the entries read-out from the one-dimensional codebook comprises a perceptual weighting filter (28).

3.  A system as claimed in Claim 1 or 2, characterised in that the means for filtering the digitised speech samples comprises a short term predictor (24) having a transfer function $A(z)$ and a filter (26) having a transfer function $1/A(z/\gamma)$, where $\gamma$ is a perceptual weighting coefficient, and in that there is provided means (32) for deriving the coefficients for the short term predictor and the filter by linear predictive analysis of the digitised speech samples.

4.  A system as claimed in Claim 3, when appended to Claim 2, characterised in that the transfer function of the perceptual weighting filter (28) is $1/A(z/\gamma_2)$ with $\gamma_2$ being different from $\gamma$ in the transfer function $1/A(z/y)$.

5.  A system as claimed in Claim 4, characterised in that the means (34, 36, 48) for comparing the filtered codebook entries with the perceptually weighted speech samples is adapted to search every pth entry, where p is greater than unity.

6.  A system as claimed in any one of Claims 1 to 5, characterised in that said means (34, 36, 48) for comparing is adapted to effect the comparison by calculating the sum of the cross products using the expression:

$$\frac{\left(\sum_{n=0}^{\frac{N}{m}-1} x\,(nm)\ g_k\,(nm)\right)^2}{\sum_{n=0}^{\frac{N}{m}-1} g_k^{\,2}\ (nm)}$$

where

N is the number of digitised samples in a frame,

n is the sample number,

x is the signal being matched with the codebook,

m is an integer having a low value

$g_k$ is the unscaled filtered codebook sequence, and

k is the codebook index.

7. A system as claimed in any one of Claims 1 to 6, characterised in that there are provided means for forming a dynamic adaptive codebook from scaled entries selected from the filtered codebook, means for comparing entries from the dynamic adaptive codebook with perceptually weighted speech samples, means for determining an index which gives the smallest difference between the dynamic adaptive codebook entry and the perceptually weighted speech samples, means for subtracting the determined index from the perceptually weighted speech samples, and means for comparing the difference signal obtained from the subtraction with entries from the filtered codebook to obtain the filtered codebook index which gives the best match.

8. A system as claimed in Claim 7, characterised in that there are provided means for combining the filtered codebook entry which gives the best match with the corresponding dynamic adaptive codebook entry to form coded perceptually weighted speech samples, and filtering means (50, 52 or 50', 52') for filtering the coded perceptually weighted speech samples to provide synthesised speech.

9. A system as claimed in Claim 8, characterised in that the dynamic adaptive codebook comprises a first-in, first out storage device of predetermined capacity and in that the input signals to the storage device comprise the coded perceptually weighted speech samples.

10. A system as claimed in Claim 8 or 9, characterised in that the filtering means for filtering the coded perceptually weighted samples comprise means for producing an inverse transfer function compared to the transfer function used to produce the perceptually weighted speech samples.

11. A method of encoding speech in which digitised speech samples are filtered to produce perceptually weighted speech samples, characterised by filtering a one-dimensional codebook in its entirety to form a filtered codebook, and comparing the perceptually weighted speech samples with entries from the filtered codebook to obtain a codebook index which gives the minimum perceptually weighted error when the speech is resynthesised.

12. A method as claimed in Claim 11, characterised in that the codebook entries are filtered using a perceptive weighting filter.

13. A method as claimed in Claim 11 or 12, characterised in that the digitised speech samples are filtered using a short term predictor with a transfer function $A(z)$ and a filter having a transfer function $1/A\,(z/\gamma)$, where $\gamma$ is the perceptual weighting coefficient, and in that the coefficients for the short term predictor and the filter are derived by linear predictive analysis of the digitised speech samples.

14. A method as claimed in Claim 13, when appended to Claim 12, characterised in that the transfer function of the perceptual weighting filter is $1/A\,(z/\gamma_2)$ with $\gamma_2$ being different from $\gamma$ in the transfer function $1/A\,(z/\gamma)$.

**15.** A method as claimed in Claim 14, characterised in that the every pth filtered codebook entry is searched, where p is greater than unity.

**16.** A method as claimed in any one of Claims 11 to 15, characterised in that the comparison of the perceptually weighted speech samples with entries from the filtered codebook is by calculating the sum of the cross products using the expression

$$\frac{\left(\sum_{\substack{n=0}}^{\substack{N-1 \\ m}} x\,(nm)\ g_k\,(nm)\right)^2}{\sum_{\substack{n=0}}^{\substack{N-1 \\ m}} g_k^2\,(nm)}$$

where

N is the number of digitised samples in a frame,
n is the sample number,
x is the signal being matched with the codebook,
$g_k$ is the unscaled codebook sequence,
k is the codebook index, and
m is an integer having a low value.

**17.** A method as claimed in any one of Claims 11 to 16, characterised by forming dynamic adaptive codebook from scaled entries selected from the filtered codebook, comparing entries from the dynamic adaptive codebook with perceptually weighted speech samples, determining an index which gives the smallest difference between the dynamic adaptive codebook entry and the perceptually weighted speech samples, subtracting the determined entry from the perceptually weighted speech samples and comparing the difference signal obtained by the subtraction with entries from the filtered codebook to obtain the filtered codebook index which gives the best match.

**18.** A method as claimed in Claim 17, characterised by combining the filtered codebook entry which gives the best match with the corresponding dynamic adaptive codebook entry to form coded perceptually weighted speech samples and filtering the coded perceptually weighted speech samples to provide synthesised speech.

**19.** A method as claimed in Claim 18, characterised in that the coded perceptually weighted samples are filtered using a transfer function which is the inverse of that to produce the perceptually weighted speech samples.

**20.** A method of deriving speech comprising forming a filtered codebook by filtering a one-dimensional codebook using a filter whose coefficients are specified in an input signal, selecting from the filtered codebook a predetermined sequence specified by a codebook index in the input signal, adjusting the amplitude of the selected predetermined sequence in response to a gain signal contained in the input signal, restoring the pitch of the selected predetermined sequence in response to pitch predictor index and gain signals contained in the input signal, and applying the pitch restored sequence to deweighting and inverse synthesis filters to produce a speech signal.

**Patentansprüche**

**1.** Sprachcodierungssystem mit Mitteln (24, 26) zum Filtern digitalisierter Sprachabtastwerte zum Bilden wahrnehmbar gewichteter Sprachabtastwerte, gekennzeichnet durch ein eindimensionales Codebuch (110), Mittel (28) zum Filtern von Eingangswerten, ausgelesen aus dem eindimensionalen Codebuch zum Liefern eines gefilterten Codebuchs (37), zusammengesetzt aus allen genannten gelesenen Eingangswerten, und Mittel (34, 36, 48) zum Vergleichen von Eingangswerten des gefilterten Codebuchs mit den wahrnehmbar gewichteten Sprachabtastwerten zum Erhalten eines Codebuchindexes, der den minimalen wahrnehmbar gewichteten Fehler ergibt, wenn die Sprache neu-synthetisiert wird.

2. System nach Anspruch 1, <u>dadurch gekennzeichnet,</u> daß die Mittel zum Filtern der aus dem eindimensionalen Codebuch ausgelesenen Eingangswerte ein Filter (28) zur wahrnehmaren Gewichtung aufweist.

3. System nach Anspruch 1 oder 2, <u>dadurch gekennzeichnet</u>, daß die Mittel zum Filtern der digitalisierten Sprachabtastwerte einen Kurzzeitprädiktor (24) aufweisen mit einer Übertragungsfunktion A(z) und ein Filter (26) mit einer Übertragungsfunktion $1/A(z/\gamma)$, wobei $\gamma$ ein wahrnehmbare Gewichtungskoeffizient ist, und daß Mittel (32) vorgesehen sind zum Herleiten der Koeffizienten für den Kurzzeitprädiktor und das Filter durch lineare prädiktive Analyse der digitalisierten Sprachabtastwerte.

4. System nach Anspruch 3, wenn abhängig von Anspruch 2, <u>dadurch gekennzeichnet</u>, daß die Übertragungsfunktion des Filters (28) für wahrnehmbare Gewichtung $1/A(z/\gamma_2)$ ist, wobei $\gamma_2$ von $\gamma$ in der Übertragungsfunktion $1/A(z/\gamma)$ abweicht.

5. System nach Anspruch 4, <u>dadurch gekennzeichnet,</u> daß die Mittel (34, 36, 48) zum Vergleichen der Eingangswerte des gefilterten Codebuchs mit den wahrnahmbar gewichteten Sprachabtastwerten jeden p. Eingangswert untersucht, wobei p größer ist als eins.

6. System nach einem der Ansprüche 1 bis 5, <u>dadurch gekennzeichnet,</u> daß die genannten Mittel (34, 36, 48) zum Vergleichen die Vergleichung durchführen durch Berechnung der Summe der Kreuzprodukte unter Anwendung des nachfolgenden Ausdrucks:

$$\frac{(\sum_{n=0}^{\substack{N-1 \\ m}} x(n)g_k(n))^2}{\sum_{n=0}^{\substack{N-1 \\ m}} g_k^2(n)}$$

wobei

N die Anzahl digitalisierter Abtastwerte in einem Rahmen ist,
n die Abtastwertnummer ist,
x das Signal ist, das dem Codebuch entspricht,
$g_k$ die nicht-skalierte gefilterte Codebuchfolge ist und
k der Codebuchindex ist.

7. System nach einem der Ansprüche 1 bis 6, <u>dadurch gekennzeichnet,</u> daß Mittel vorgesehen sind zum Bilden eines dynamisch adaptiven Codebuchs aus skalierten Eingangswerten, selektiert aus dem gefilterten Codebuch, Mittel zum Vergleichen von Eingangswerten aus dem dynamisch adaptiven Codebuch mit wahrnehmbar gewichteten Sprachabtastwerten, Mittel zum Bestimmen eines Indexes, der die kleinste Differenz zwischen dem dynamisch adaptiven Codebucheingangswert und den wahrnehmbar gewichteten Sprachabtastwerten ergibt, Mittel zum Subtrahieren des festgestellten Indexes von den wahrnehmbar gewichteten Sprachabtastwerten, und Mittel zum Vergleichen des Differenzsignals, erhalten aus der Subtraktion mit Eingangswerten von dem gefilterten Codebuch zum Erhalten des gefilterten Codebuchindexes, was zu der besten Anpassung führt.

8. System nach Anspruch 7, <u>dadurch gekennzeichnet</u>, daß Mittel vorgesehen sind zum Kombinieren des gefilterten Codebucheingangswertes, was die beste Anpassung ergibt, mit dem entsprechenden dynamisch adaptiven Codebucheingangswert zum Bilden codierter wahrnehmbar gewichteter Sprachabtastwerte, und Mittel (50, 52 oder 50', 52') zum Filtern der codierten wahrnehmbar gewichteten Sprachabtastwerte zum Schaffen synthetisierter Sprache.

9. System nach Anspruch 8, <u>dadurch gekennzeichnet,</u> daß das dynamisch adaptive Codebuch eine FIFO-Speicheranordnung einer vorbestimmter Kapazität aufweist und daß die Eingangssignale zu der Speicheranordnung die codierten wahrnehmbar gewichteten Sprachabtastwerte enthalten.

10. System nach Anspruch 8 oder 9, <u>dadurch gekennzeichnet</u>, daß die Filtermittel zum Filtern der codierten wahrnehmbar gewichteten Abtastwerte Mittel aufweisen zum Erzeugen einer inversen Übertragungsfunktion im Vergleich zu der Übertragungsfunktion, die zum Erzeugen der wahrnehmbar gewichteten Sprachabtastwerte benutzt wird.

11. Verfahren zum Codieren von Sprache, wobei digitalisierte Sprachabtastwerte gefiltert werden zum Erzeugen wahrnehmbar gewichteter Sprachabtastwerte, gekennzeichnet durch Filterung eines eindimensionalen Codebuches als Ganzes zum Bilden eines gefilterten Codebuchs und durch Vergleichung der wahrnehmbar gewichteten Sprachabtastwerte mit Eingangswerten von dem gefilterten Codebuch zum Erhalten eines Codebuchindexes, der den minimalen wahrnehmbar gewichteten Fehler ergibt, wenn die Sprache neu-synthetisiert wird.

12. Verfahren nach Anspruch 11, <u>dadurch gekennzeichnet</u>, daß die Codebuch-Eingangswerte unter Verwendung eines Filters zur wahrnehmbaren Gewichtung gefiltert werden.

13. Verfahren nach Anspruch 11 oder 12, <u>dadurch gekennzeichnet</u>, daß die digitalisierten Sprachabtastwerte unter Verwendung eines Kurzzeitprädiktors mit einer Übertragungsfunktion A(z) und eines Filters mit einer Übertragungsfunktion $1/A(z/\gamma)$, wobei $\gamma$ der wahrnehmbare Gewichtungskoeffizient ist, gefiltert werden und daß die Koeffizienten für den Kurzzeitprädiktor und das Filter durch lineare prädiktive Analyse der digitalisierten Sprachabtastwerte hergeleitet werden.

14. Verfahren nach Anspruch 13, wenn abhängig von Anspruch 12, <u>dadurch gekennzeichnet,</u> daß die Übertragungsfunktion des Filters zur wahrnehmbaren Gewichtung $1/A(z/\gamma_2)$ ist, wobei $\gamma_2$ von $\gamma$ in der Übertragungsfunktion $1/A(z/\gamma)$ abweicht.

15. Verfahren nach Anspruch 14, <u>dadurch gekennzeichnet</u>, daß jeder p. Eingangswert des gefilterten Codebuchs untersucht wird, wobei p größer als eins ist.

16. Verfahren nach einem der Ansprüche 11 bis 15, <u>dadurch gekennzeichnet,</u> daß die Vergleichung durch Berechnung der Summe der Kreuzprodukte unter Anwendung der nachfolgenden Gleichung erfolgt:

$$\frac{\left(\sum_{n=0}^{\frac{N-1}{m}} x(n)g_k(n)\right)^2}{\sum_{n=0}^{\frac{N-1}{m}} g_k^2(n)}$$

wobei

N die Anzahl digitalisierter Abtastwerte in einem Rahmen ist,
n die Abtastwertnummer ist,
x das Signal ist, das dem Codebuch entspricht,
$g_k$ die nicht-skalierte gefilterte Codebuchfolge ist und
k der Codebuchindex und
m eine ganze Zahl niedrigen Wertes ist.

17. Verfahren nach einem der Ansprüche 11 bis 16, gekennzeichnet durch die Bildung eines dynamisch adaptiven Codebuchs aus skalierten Eingangswerten, selektiert aus dem gefilterten Codebuch, das Vergleichen von Eingangswerten aus dem dynamisch adaptiven Codebuch mit wahrnehmbar gewichteten Sprachabtastwerten, das Bestimmen eines Indexes, der die kleinste Differenz zwischen dem dynamisch adaptiven Codebucheingangswert und den wahrnehmbar gewichteten Sprachabtastwerten ergibt, das Subtrahieren des festgestellten Eingangswertes aus den wahrnehmbar gewichteten Sprachabtastwerten, und das Vergleichen des Differenzsignals, erhalten

EP 0 413 391 B1

aus der Subtraktion mit Eingangswerten von dem gefilterten Codebuch zum Erhalten des gefilterten Codebuchindexes, was zu der besten Anpassung führt.

**18.** Verfahren nach Anspruch 17, gekennzeichnet durch das Kombinieren des gefilterten Codebucheingangswertes, was die beste Anpassung ergibt, mit dem entsprechenden dynamisch adaptiven Codebucheingangswert zum Bilden codierter wahrnehmbar gewichteter Sprachabtastwerte, und das Filtern der codierten wahrnehmbar gewichteten Sprachabtastwerte zum Schaffen synthetisierter Sprache.

**19.** Verfahren nach Anspruch 18, <u>dadurch gekennzeichnet</u>, daß die codierten wahrnehmbar gewichteten Abtastwerte unter Anwendung einer Übertragungsfunktion gefiltert werden, welche die Inverse von derjenigen ist, die vorgesehen ist zum Erzeugen der wahrnehmbar gewichteten Sprachabtastwerte.

**20.** Verfahren zum Herleiten von Sprache mit den nachfolgenden Verfahrensschritten: das Bilden eines gefilterten Codebuchs durch Filterung eines eindimensionalen Codebuchs unter Verwendung eines Filters, dessen Koeffizienten in einem Eingangssignal spezifiziert sind, das Selektieren einer vorbestimmten Folge aus dem gefilterten Codebuch, wobei diese Folge durch einen Codebuchindex in dem Eingangssignal spezifiziert ist, das Einstellen der Amplitude der selektierten vorbestimmten Folge in Antwort auf ein Verstärkungssignal in dem Eingangssignal, das Wiederherstellen des Pitches der selektierten vorbestimmten Folge in Antwort auf den Pitch-Prädiktorindex und Verstärkungssignal in dem Eingangssignal, und das Zuführen der im Pitch wiederhergestellten Folge zu Entgewichtungs- und inversen Synthesefiltern zum Erzeugen eines Sprachsignals.

**Revendications**

**1.** Système de codage de parole comprenant des moyens (24, 26) pour filtrer des échantillons de parole numérisés afin de former des échantillons de parole perceptuellement pondérés, caractérisé par une table de codage unidimensionnelle (110), des moyens (28) pour filtrer des entrées extraites de la table de codage unidimensionnelle afin d'obtenir une table de codage filtrée (37) composée de toutes lesdites entrées extraites, et des moyens (34, 36, 48) pour comparer les entrées de la table de codage filtrée aux échantillons de parole perceptuellement pondérés afin d'obtenir un indice de table de codage qui donne l'erreur minimum perceptuellement pondérée lorsque la parole est resynthétisée.

**2.** Système selon la revendication 1, caractérisé en ce que les moyens pour filtrer les entrées extraites de la table de codage unidimensionnelle comprennent un filtre de pondération perceptuelle (28).

**3.** Système selon la revendication 1 ou 2, caractérisé en ce que les moyens pour filtrer les échantillons de parole numérisés comprennent un prédicteur à court terme (24) ayant une fonction de transfert A(z) et un filtre (26) ayant une fonction de transfert $1/A(z/\gamma)$, où $\gamma$ est un coefficient de pondération perceptuelle, et en ce qu'un moyen (32) est prévu pour obtenir les coefficients pour le prédicteur à court terme et le filtre par analyse prédictive linéaire des échantillons de parole numérisés.

**4.** Système selon la revendication 3, dans la mesure où elle découle de la revendication 2, caractérisé en ce que la fonction de transfert du filtre de pondération perceptuelle (28) est $1/A(z/\gamma_2)$, $\gamma_2$ étant différent de $\gamma$ dans la fonction de transfert $1/A(z/\gamma)$.

**5.** Système selon la revendication 4, caractérisé en ce que les moyens (34, 36, 48) destinés à comparer les entrées de la table de codage filtrée aux échantillons de parole perceptuellement pondérés sont à même d'analyser chaque $p^{ème}$ entrée, où p est supérieur à l'unité.

**6.** Système selon l'une quelconque des revendications 1 à 5, caractérisé en ce que lesdits moyens de comparaison (34, 36, 48) sont à même d'effectuer la comparaison en calculant la somme des produits géométriques en utilisant l'expression :

$$\frac{\left(\displaystyle\sum_{n=0}^{\frac{N-1}{m}} x(nm)\ g_k(nm)\right)^2}{\displaystyle\sum_{n=0}^{\frac{N-1}{m}} g_k^2(nm)}$$

où :

N est le nombre d'échantillons numérisés dans une trame,
n est le nombre d'échantillons,
x est le signal adapté à la table de codage,
m est un nombre entier ayant une faible valeur,
$g_k$ est la séquence de la table de codage filtrée non mise à l'échelle, et
k est l'indice de table de codage.

7. Système selon l'une quelconque des revendications 1 à 6, caractérisé en ce que sont prévus des moyens pour former une table de codage adaptative dynamique à partir d'entrées mises à l'échelle sélectionnées dans la table de codage filtrée, des moyens pour comparer des entrées de la table de codage adaptative dynamique à des échantillons de parole perceptuellement pondérés, des moyens pour déterminer un indice qui donne la plus petite différence entre l'entrée de table de codage adaptative dynamique et les échantillons de parole perceptuellement pondérés, des moyens pour soustraire l'indice déterminé des échantillons de parole perceptuellement pondérés, et des moyens pour comparer le signal de différence obtenu par la soustraction avec des entrées de la table de codage filtrée afin d'obtenir l'indice de table de codage filtrée qui donne la meilleure adaptation.

8. Système selon la revendication 7, caractérisé en ce que sont prévus des moyens pour combiner l'entrée de table de codage filtrée qui donne la meilleure adaptation avec l'entrée correspondante de table de codage adaptative dynamique pour former des échantillons codés de parole perceptuellement pondérés, et des moyens de filtrage (50, 52 ou 50', 52') pour filtrer les échantillons codés de parole perceptuellement pondérés afin d'obtenir une parole synthétisée.

9. Système selon la revendication 8, caractérisé en ce que la table de codage adaptative dynamique peut comprendre un dispositif de stockage FIFO de capacité prédéterminée et en ce que les signaux d'entrée dans le dispositif de stockage comprennent les échantillons codés de parole perceptuellement pondérés.

10. Système selon la revendication 8 ou 9, caractérisé en ce que les moyens de filtrage pour filtrer les échantillons codés de parole perceptuellement pondérés peuvent comprendre des moyens pour produire une fonction de transfert inverse comparée à la fonction de transfert utilisée pour produire les échantillons de parole perceptuellement pondérés.

11. Procédé de codage de parole dans lequel des échantillons de parole numérisés sont filtrés pour produire des échantillons de parole perceptuellement pondérés, caractérisé en ce qu'on filtre une table de codage unidimensionnelle dans sa totalité pour former une table de codage filtrée, et on compare les échantillons de parole perceptuellement pondérés à des entrées de la table de codage filtrée afin d'obtenir un indice de table de codage qui donne l'erreur minimum perceptuellement pondérée lorsque la parole est resynthétisée.

12. Procédé selon la revendication 11, caractérisé en ce que les entrées de la table de codage sont filtrées en utilisant un filtre de pondération perceptuelle.

13. Procédé selon la revendication 11 ou 12, caractérisé en ce que les échantillons de parole numérisés sont filtrés en utilisant un prédicteur à court terme avec une fonction de transfert $A(z)$ et un filtre ayant une fonction de transfert $1/A(z/\gamma)$, où $\gamma$ est le coefficient de pondération perceptuelle, et en ce que les coefficients pour le prédicteur à court terme et le filtre sont obtenus par analyse prédictive linéaire des échantillons de parole numérisés.

14. Procédé selon la revendication 13, dans la mesure où elle découle de la revendication 12, caractérisé en ce que la fonction de transfert du filtre de pondération perceptuelle est $1/A(z/\gamma_2)$, $\gamma_2$ étant différent de $\gamma$ dans la fonction de transfert $1/A(z/\gamma)$.

**15.** Procédé selon la revendication 14, caractérisé en ce qu'on analyse chaque $p^{\text{ème}}$ entrée de la table de codage filtrée, où p est supérieur à l'unité.

**16.** Procédé selon l'une quelconque des revendications 11 à 15, caractérisé en ce que la comparaison des échantillons de parole perceptuellement pondérés avec des entrées de la table de codage filtrée se fait par calcul de la somme des produits géométriques en utilisant l'expression :

$$\frac{\left(\sum_{n=0}^{\frac{N-1}{m}} x(nm)\ g_k(nm)\right)^2}{\sum_{n=0}^{\frac{N-1}{m}} g_k^2(nm)}$$

où

N est le nombre d'échantillons numérisés dans une trame,
n est le nombre d'échantillons,
x est le signal adapté à la table de codage,
$g_k$ est la séquence de la table de codage non mise à l'échelle,
k est l'indice de table de codage, et
m est un nombre entier ayant une faible valeur.

**17.** Procédé selon l'une quelconque des revendications 11 à 16, caractérisé en ce que l'on forme une table de codage adaptative dynamique à partir d'entrées mises à l'échelle sélectionnées dans la table de codage filtrée, on compare les entrées de la table de codage adaptative dynamique à des échantillons de parole perceptuellement pondérés, on détermine un indice qui donne la plus petite différence entre l'entrée de table de codage adaptative dynamique et les échantillons de parole perceptuellement pondérés, on soustrait l'entrée déterminée des échantillons de parole perceptuellement pondérés et on compare le signal de différence obtenu par la soustraction avec des entrées de la table de codage filtrée pour obtenir l'indice de la table de codage filtrée qui donne la meilleure adaptation.

**18.** Procédé selon la revendication 17, caractérisé en ce que l'on combine l'entrée de la table de codage filtrée qui donne la meilleure adaptation avec l'entrée correspondante de la table de codage adaptative dynamique pour former des échantillons codés de parole perceptuellement pondérés et on filtre les échantillons codés de parole perceptuellement pondérés pour obtenir une parole synthétisée.

**19.** Procédé selon la revendication 18, caractérisé en ce que les échantillons codés perceptuellement pondérés sont filtrés en utilisant une fonction de transfert qui est l'inverse de celle utilisée pour produire les échantillons de parole perceptuellement pondérés.

**20.** Procédé d'obtention de parole consistant à former une table de codage filtrée en filtrant une table de codage unidimensionnelle au moyen d'un filtre dont les coefficients sont spécifiés dans un signal d'entrée, à sélectionner dans la table de codage filtrée une séquence prédéterminée spécifiée par un indice de table de codage dans le signal d'entrée, à ajuster l'amplitude de la séquence prédéterminée sélectionnée en réaction à un signal de gain contenu dans le signal d'entrée, à rétablir la hauteur de la séquence prédéterminée sélectionnée en réaction à des signaux d'indice du prédicteur de hauteur et de gain contenus dans ledit signal d'entrée, et à appliquer la séquence rétablie de la hauteur à des filtres de dépondération et de synthèse inverse pour produire un signal de parole.

*Fig.1.*

*Fig.2.*

EP 0 413 391 B1

Fig. 3.

Fig. 4.